# EUROPEAN PATENT APPLICATION

(11) **EP 1 615 151 A1**
(43) Date of publication of application: **11.01.2006**
(21) Application number: 04771269.0
(22) Date of filing: 05.08.2004
(51) Int. Cl.: G06F 17/50, H05K 3/00, G01R 29/08

(54) **METHOD AND DEVICE FOR ELECTROMAGNETIC FIELD ANALYSIS OF CIRCUIT BOARD, AND CIRCUIT BOARD AND ITS DESIGN METHOD**

(30) Priority: 07.08.2003 JP 2003288703
(71) Applicant: MATSUSHITA ELECTRIC INDUSTRIAL CO., LTD., Kadoma-shi, Osaka 571-8501 (JP)
(72) Inventor: URIU, Kazuhide, Osaka 572-0086 (JP); YAMADA, Toru, Osaka 576-0033 (JP); SASAKI, Yukinori, Hyogo 662-0032 (JP)
(74) Representative: Eisenführ, Speiser & Partner
(86) International application number: PCT/JP2004/011242
(87) International publication number: WO 2005/015449

(57) **Abstract**

A method for analyzing an electromagnetic field includes: a step S1 for setting up initial shapes of conductor patterns in each layer of a multilayer circuit board; a step S2 for setting up initial ports for input or output of an external signal in each conductor pattern; a step S3 for dividing two-dimensionally the multilayer circuit board into a plurality of areas; steps S4a and S4b for setting up additive ports on edges of the conductor pattern which has been created by area-division; steps S5a and S5b for setting up individual analysis conditions for the initial ports and the additive ports, respectively; steps S6a and S6b for performing an electromagnetic analysis of the multilayer circuit board by the divided area, based on the analysis conditions; and a step S8 for integrating results of the electromagnetic analysis over each of the divided areas, thereby obtaining results of the electromagnetic analysis over the whole circuit board.

By using this approach, an EM analysis of a multilayer circuit board can run quickly to significantly reduce time and cost required for designing the circuit board.

## Description

### [TECHNICAL FIELD]

The present invention relates to a method and an apparatus for analyzing an electromagnetic field of a circuit board, which is used in various electronics, and also to a circuit board and a method for designing the same.

### [BACKGROUND]

Conventionally, approaches of designing a circuit board using an EM(electromagnetic field) simulation have been made, because a conventional electronics has increasingly required higher accuracy and the circuit board has been configured of a plurality of layers with conductor patterns to downsize and integrate it densely. In particular, because of EMI(electromagnetic interference) between conductor patterns, it was difficult to obtain such characteristics as initially designed using only designer's experiences. Therefore, an analyzing method using an EM analysis simulator has been considered. Conventional EM simulators, such as ADS Momentum supplied by Agilent Technologies, Sonnet supplied by Sonnet, and RF Designer supplied by Ansoft, are known.

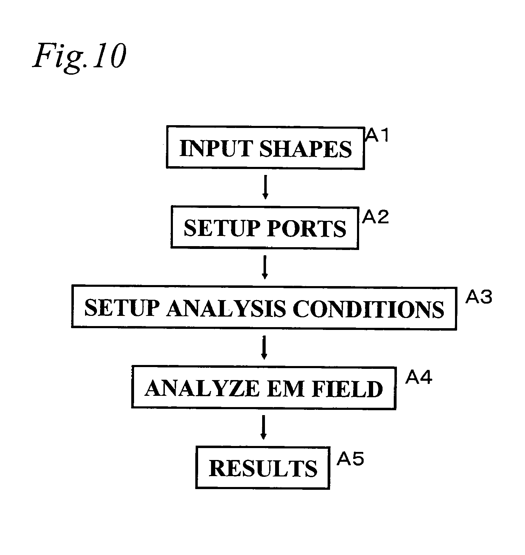

Fig. 10 is a flowchart showing an example of a conventional EM simulation. Firstly, in a step A1, initial shapes of conductor patterns in each layer of a multilayer circuit board are set up. Next, in a step A2, initial ports for input or output of an external signal are set up in each conductor pattern. Next, in a step A3, individual analysis conditions for each of the initial ports and the like are set up. Next, in a step A4, an EM analysis of the multilayer circuit board is performed based on the analysis conditions. Next, in a step A5, results of the EM analysis are obtained.

However, such a conventional circuit board will be quite expensive. Since the above-mentioned circuit board has a plurality of layers with conductor patterns while downsizing and integrating it densely, the various conductor patterns may electromagnetically interfere with each other. When designing all the conductor patterns using an EM simulation to avoid the interference, calculation for optimal design to verify various combinations using the EM simulation may take at least several weeks, because the circuit board is provided with a large number of conductor patterns.

Designing one circuit board using an EM simulation for many days may increase the cost of the circuit board. Meanwhile, EMI(EM interference) between devices can be eliminated by arranging each of the devices only in a horizontal direction. But there must be lines for connecting the devices to each other, resulting in various EMI between the lines or between the lines and the devices. Therefore, as described above, it is difficult to obtain desired characteristics even after designing for a long time, thereby increasing the cost of the circuit board.

Incidentally, the following patent document 1 discloses a method for designing a circuit board, wherein EMI between devices can be eliminated by arranging each of the devices only in a horizontal direction.

[PATENT DOCUMENT 1] JP-2003-16133 A, pages 5-8, Fig. 1

### [DISCLOSURE OF THE INVENTION]

### [PROBLEM TO BE SOLVED BY THE INVENTION]

It is an object of the present invention to provide a method and an apparatus for analyzing an electromagnetic field of a circuit board, and a circuit board and a method for designing the same, in which electromagnetic analysis for a multilayer circuit board can be performed quickly to significantly reduce time and cost required for designing the circuit board.

### [MEANS FOR SOLVING THE PROBLEM]

A method for analyzing an electromagnetic field of a circuit board, according to the present invention, based on shapes of conductor patterns and signal analysis conditions includes steps of:
setting up initial shapes of conductor patterns in each layer of a multilayer circuit board;
setting up initial ports for input or output of an external signal in each conductor pattern;
dividing two-dimensionally the multilayer circuit board into a plurality of areas;
setting up additive ports on edges of the conductor pattern which has been created by area-division;
setting up individual analysis conditions for the initial ports and the additive ports, respectively;
performing an electromagnetic analysis of the multilayer circuit board by the divided area, based on the analysis conditions; and
integrating results of the electromagnetic analysis over each of the divided areas, thereby obtaining results of the electromagnetic analysis over the whole circuit board.

It is preferable in the present invention to divide two-dimensionally the multilayer circuit board into a plurality of areas using dividing lines including a plurality of straight lines parallel to each other in the dividing step.

It is preferable in the present invention to divide two-dimensionally the multilayer circuit board into a plurality of areas using dividing lines including a plurality of straight lines perpendicular to each other in the dividing step.

It is preferable in the present invention to divide two-dimensionally the multilayer circuit board into a plurality of areas using dividing lines including a polygonal line or a curved line in the dividing step.

It is preferable in the present invention to designate shapes of the dividing lines using a pointing device while representing a plan view of the multilayer circuit board on a display screen in the dividing step.

It is preferable in the present invention to calculate the number of the edges of the conductor pattern created by area-division.

It is preferable in the present invention to add the ports, the number of which corresponds to the calculated number of the edges, in the setting up the additive ports.

It is preferable in the present invention to add the port in the center of the edge, in the setting up the additive ports.

It is preferable in the present invention that when a position of one port located on the edge of a conductor pattern residing in one layer coincides with a position of another port located on the edge of another conductor pattern residing in another layer, one of the ports is displaced to be represented on a display screen.

It is preferable in the present invention that the method further includes steps of:
changing the shape of the conductor pattern residing in a particular divided area, to perform again the electromagnetic analysis over the particular divided area; and
integrating a result of the electromagnetic analysis over the particular divided area with the result of the electromagnetic analysis over the another divided area, thereby obtaining results of the electromagnetic analysis over the whole circuit board.

An apparatus for analyzing an electromagnetic field of a circuit board, according to the present invention, based on shapes of conductor patterns and signal analysis conditions includes:
means for setting up initial shapes of conductor patterns in each layer of a multilayer circuit board;
means for setting up initial ports for input or output of an external signal in each conductor pattern;
means for dividing two-dimensionally the multilayer circuit board into a plurality of areas;
means for setting up additive ports on edges of the conductor pattern which is created by area-division;
means for setting up individual analysis conditions for the initial ports and the additive ports, respectively;
means for performing an electromagnetic analysis of the multilayer circuit board by the divided area, based on the analysis conditions; and
means for integrating results of the electromagnetic analysis over each of the divided areas, thereby obtaining results of the electromagnetic analysis over the whole circuit board.

A circuit board according to the present invention, with a rectangular shape includes:
a plurality of layers having conductor patterns; and
a plurality of spiral inductance patterns provided in the conductor patterns;
wherein three out of the plurality of spiral inductance patterns are located on at least three of corner portions of the circuit board.

It is preferable in the present invention that the spiral inductance pattern is located on each of the three corner portions of the circuit board so that the shortest distance L1 from the apex of the corner portion to the spiral inductance pattern and a diameter L2 of a circumcircle of the spiral inductance pattern satisfy a relation: L1 ≤ L2.

A lamination device according to the present invention, includes:
the above-mentioned circuit board; and
a semiconductor integrated circuit mounted on the circuit board.
A method for designing a circuit board, according to the present invention, the circuit board including a plurality of layers having conductor patterns in which a plurality of spiral inductance patterns are provided, includes steps of:
dividing the circuit board into a plurality of divided areas using a dividing line; and
designing a circuit pattern over each of the divided areas using simulation,
wherein the dividing line is set up so as not to cut off two or more out of the plurality of spiral inductance patterns provided in the circuit board.

It is preferable in the method for designing a circuit board, according to the present invention, the circuit board including a plurality of layers having conductor patterns in which a plurality of spiral inductance patterns are provided, that three out of the plurality of spiral inductance patterns are located on at least three of corner portions of the circuit board.

### [EFFECT OF THE INVENTION]

In the method and the apparatus for analyzing an electromagnetic field of a circuit board, according to the present invention, after dividing the circuit board into a plurality of areas, results obtained by performing the electromagnetic analysis over each of the divided areas are integrated. This approach can drastically shorten running time of the electromagnetic analysis, and time and cost required for designing the circuit board can be significantly reduced. Further, since the result of the simulation can be obtained quickly, it is easy to give feedback to design of the circuit board, thereby optimizing the design of the circuit board.

Furthermore, in the circuit board and the method for designing the same, according to the present invention, simulation time of the circuit board including a plurality of layers having conductor patterns in which a plurality of spiral inductance patterns are provided can be drastically shortened, thereby contributing to reduce cost of the circuit board. Further, this result is almost equal to a result obtained by simulation without division, enabling design sufficient for practice use.

### [BRIEF DESCRIPTION OF THE DRAWINGS]

Fig. 1 is a flowchart showing an example of an electromagnetic simulation according to the present invention.
Figs. 2A to 2E are explanatory views illustrating operation status of the simulation.
Figs. 3A to 3C are explanatory views illustrating another example of area division in the electromagnetic simulation according to the present invention.
Figs. 4A to 4C are explanatory views illustrating yet another example of area division in the electromagnetic simulation according to the present invention.
Fig. 5 is a block diagram showing an antenna switch circuit according to a fourth embodiment of the present invention.
Fig. 6 is a circuit diagram of the antenna switch circuit.
Fig. 7 is a perspective view showing a circuit board on which the antenna switch circuit is mounted.
Fig. 8 is a plan view of the circuit board shown in Fig. 7.
Fig. 9 is a exploded perspective view of the circuit board shown in Fig. 7.
Fig. 10 is a flowchart showing an example of a conventional electromagnetic simulation.

### [EXPLANATORY NOTE]

- 1: ANTENNA TERMINAL
- 2, 3, 4: POWER SUPPLY TERMINAL
- 5: DIPLEXER
- 6, 7, 8: SWITCH CIRCUIT
- 9, 10: FILTER
- 11: GSM TRANSMITTING TERMINAL
- 12: GSM RECEIVING TERMINAL
- 13: DCS/PCS TRANSMITTING TERMINAL
- 14: DCS RECEIVING TERMINAL
- 15: PCS RECEIVING TERMINAL
- 16: CIRCUIT BOARD
- 17: ELECTRONIC PARTS
- 18 to 25: INDUCTOR
- 26 to 42: DIELECTRIC LAYER
- 43: ELECTRODE PATTERN
- 44, 45, 46: DIVIDING LINE
- 47 to 50: DIVIDED AREA
- 51 to 68: CAPACITOR
- 80: MULTILAYER CIRCUIT BOARD
- 81: ELECTRICAL INSULATING SUBSTRATE
- 82, 83: CONDUCTOR PATTERN

### [BEST EMBODIMENT FOR CARRYING OUT THE INVENTION]

Hereinafter, preferred embodiments according to the present invention will be described with reference to drawings.

### (Embodiment 1)

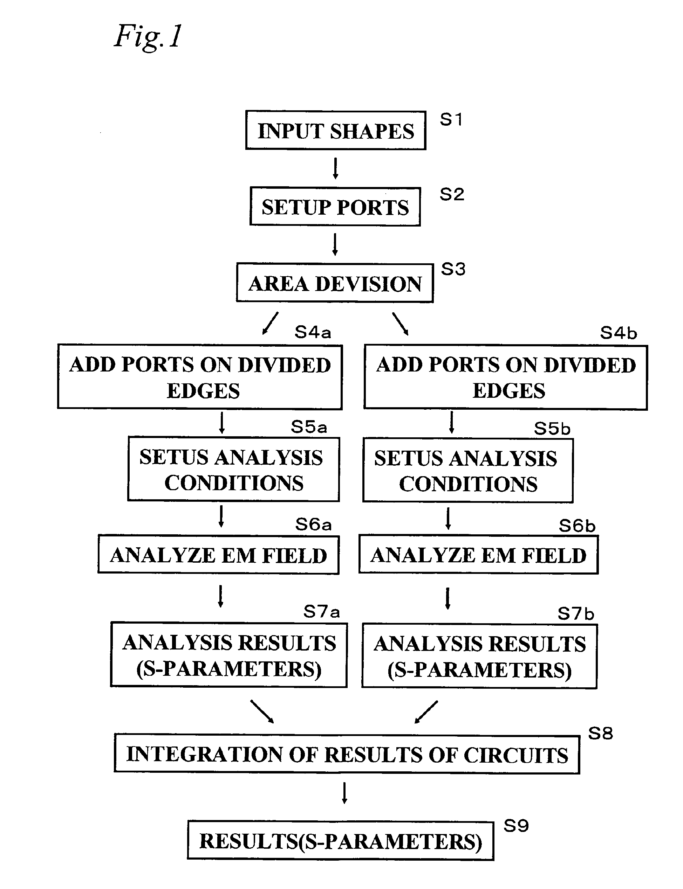

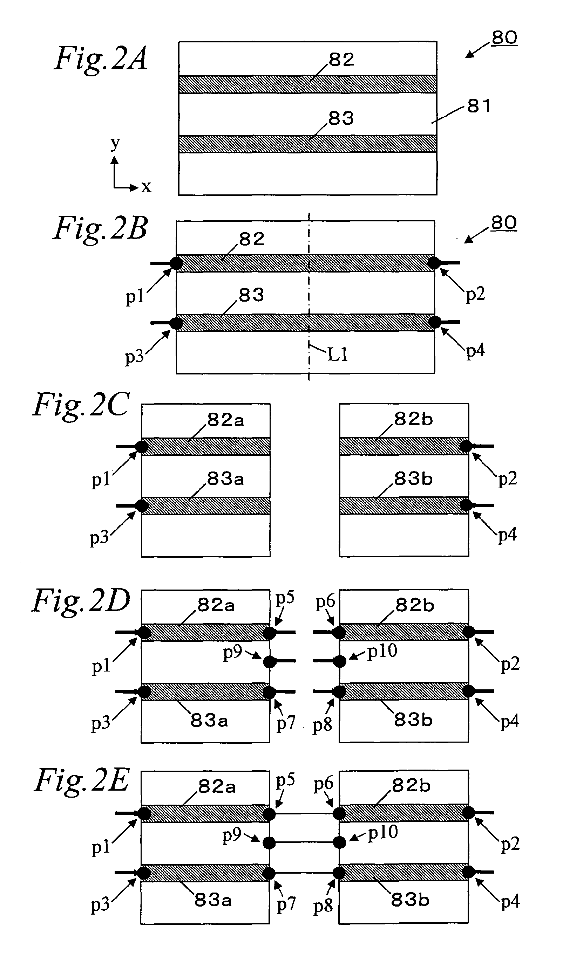

Fig. 1 is a flowchart showing an example of an electromagnetic simulation according to the present invention. Figs. 2A to 2E are explanatory views illustrating operation status of the simulation. The EM (electromagnetic) simulator is constituted of a software which can run on a personal computer. The personal computer may include a input device, such as keyboard, a pointing device, such as mouse, a display device, such as liquid crystal display panel, a mass-storage device, such as hard-disk or optical disk, a processing device, such as a micro-processor, and a network device.

Various data required for the simulation, such as shapes of conductor patterns and signal analysis conditions, can be inputted using the keyboard or the mouse, or from files stored in the mass-storage device, or through a network from another computer. Results of the simulation can be represented on a screen of the display device, or stored in the mass-storage device, or outputted through the network to another computer or a printer.

Firstly, in a step S1 shown in Fig. 1, initial shapes of conductor patterns in each layer of a multilayer circuit board are set up. The multilayer circuit board is laminated of a plurality of layers, in which each one layer includes an electrical insulating substrate of ceramics or the like and conductor patterns formed on the substrate. For example, as shown in Fig. 2A, with respect to a first layer which is positioned on the top of a multilayer circuit board 80, two conductor patterns 82 and 83 are arranged in parallel to each other along x-direction on an electrical insulating substrate 81. In a step S1, shape parameters including dimensions and positions of the conductor patterns 82 and 83 with respect to the first layer are inputted. Likewise with respect to a second layer and below, shape parameters of conductor patterns are inputted layer by layer. The shape parameters may include layer number, conductor number, origin coordinates (x, y) of conductor, pattern length, pattern width and so on. In case the conductor pattern has a circle, an ellipsoid or a curve, the shape parameters may include an additive parameter required for identifying the shape thereof, such as radius, center coordinates, or ellipticity.

Method for inputting such shapes of the conductor patterns may include direct input method by an operator and graphical input method using a CAD software, as well as by importing graphic data produced by another CAD software via a compatible data-format (e.g. DXF format) into the EM simulator, or by importing from a circuit board database file.

Next, in a step S2, initial ports for input or output of an external signal are set up in each of the conductor patterns. For example, as shown in Fig. 2B, with respect to the first layer, a port p1 is set up on the left edge of the conductor pattern 82, a port p2 is set up on the right edge thereof, a port p3 is set up on the left edge of the conductor pattern 83, and a port p4 is set up on the right edge thereof. Likewise with respect to a second layer and below, input and/or output port are set up on edges of conductor pattern in each layer. Each port can be identified by parameters, such as layer number, conductor number, position coordinates (x, y).

Next, in a step S3, the multilayer circuit board is divided two-dimensionally into a plurality of areas. For easy understanding, the following description exemplifies that the multilayer circuit board is divided into two areas, but the board may be divided into three or more areas. For example, as shown in Fig. 2B, in case the multilayer circuit board 80 is divided by a dividing line L1 which extends straightly along y-direction, a first divided area including left sections 82a and 83a of the conductor patterns 82 and 83, and a second divided area including right sections 82b and 83b of the conductor patterns 82 and 83 are partitioned in the first layer. Likewise with respect to a second layer and below, conductor patterns in each layer are also divided by the dividing line L1 into the first divided area and the second divided area.

When dividing the board into a plurality of areas, the number of the edges of the conductor pattern created by area-division is preferably calculated. For example, the number of the edges of the conductor pattern can be calculated by counting the number of intersections of the dividing line and conductor patterns in each layer. By calculation of the number of the edges, the number of ports to be added in a subsequent step can be automatically calculated, thereby attaining automatic processing.

In steps S4a to S7a shown in Fig. 1, the multilayer circuit board residing in the first divided area will be processed. In steps S4b to S7b shown in Fig. 1, the multilayer circuit board residing in the second divided area will be processed.

In steps S4a and S4b, additive ports are set up on the edges of the conductor pattern which has been created by area-division. For example, as shown in Fig. 2D, ports p5 and p7 are added on the right edge of the left sections 82a and 83a, and ports p6 and p8 are added on the left edge of the right sections 82b and 83b, respectively, in the first layer. Likewise with respect to a second layer and below, ports are added in each layer on edges of conductor pattern which has been created by area-division. Ports p9 and p10, as shown in Fig. 2D, are added on edges of conductor pattern residing in a layer other than the first layer. Each of the additive ports can be identified by parameters, such as layer number, conductor number, position coordinates (x, y), like as the initial ports.

When adding ports, operator may designate such additive ports by manual operation. Otherwise, ports may be added automatically so that the number of the additive ports corresponds to such automatically-calculated number of the edges as described above, thereby attaining automatic processing.

Further, when adding a port, in the light of signal propagation, the port is preferably added in the center of an edge of each of conductor patterns.

Next, in steps S5a and S5b, individual signal analysis conditions for the initial ports and the additive ports are set up, respectively. For example, as shown in Fig. 2D, for each of the ports p1 to p10 residing in each layer, known parameters and unknown parameters of the signal analysis conditions are set up, respectively. For the signal analysis conditions, in gerieral, complex amplitudes of an incident wave and a reflected wave defined by S (scattering) parameters, or complex amplitudes of a current and a voltage defined by F parameters (image parameters), Z parameters (open-circuit impedance parameters), or Y parameters (short-circuit admittance parameters) can be employed. In addition, for the analysis conditions on the circuit board, layer configuration of the multilayer circuit board, such as thickness of layer, arrangement of electrode, electric conductivity of electrode, dielectric constant of insulating layer and the like, may be set up.

Next, in steps S6a and S6b, an EM analysis of the multilayer circuit board is performed by the divided area, based on the analysis conditions which are set up for each port. For example, as shown in Fig. 2D, for the multilayer circuit board residing in the left first divided area, the EM analysis is performed based on the analysis conditions which are set up for each of the ports p1, p3, p5, p7 and p9. Meanwhile, for the multilayer circuit board residing in the right second divided area, the EM analysis is performed based on the analysis conditions which are set up for each of the ports p2, p4, p6, p8 and p10.

Next, a result of the EM analysis over the first divided area is obtained in a step S7a, and another result of the EM analysis over the second divided area is obtained in a step S7b. Consequently, unknown parameters, such as signal response (S parameters), of the ports p1 to p10 are calculated.

Next, in a step S8, results of the EM analysis for each of the divided areas are integrated. In a step S9, results of the EM analysis for the whole board are obtained. For example, as shown in Fig. 2E, when coupling the port p5 in the first divided area with the port p6 in the second divided area, and coupling the port p7 in the first divided area with the port p8 in the second divided area, and coupling the port p9 in the first divided area with the port p10 in the second divided area, the original multilayer circuit board as shown in Fig. 2B can be reconstructed. Consequently, results of the EM analysis with respect to the whole multilayer circuit board 80, such as S parameters of the while circuit board, can be obtained by extracting unknown parameters calculated for the initial ports p1 to p4. The resulting S parameters can be converted into F parameters, Z parameters, Y parameters and the like using a given conversion formula, if necessary.

In this embodiment, an EM simulation is not performed for the whole circuit board, but the circuit board is divided into a plurality of areas and the EM simulation is performed for each of the divided areas and the results of the EM simulation are integrated. Conventional running time of the EM simulation was about one week, but the above-described method according to the invention can reduce the running time to about 3 hours, thereby drastically reducing time and cost required for designing the circuit board. Further, since the result of the simulation can be obtained quickly, it is easy to give feedback to design of the circuit board, thereby optimizing the design of the circuit board.

### (Embodiment 2)

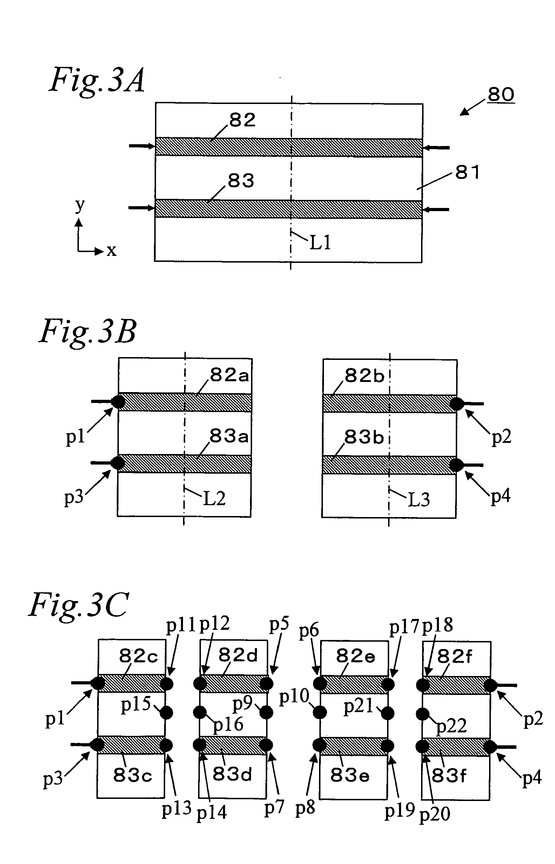

Figs. 3A to 3C are explanatory views illustrating another example of area division in the EM simulation according to the present invention. In this embodiment, operation of the EM simulation is similar to that as described above, but in the step S3 shown in Fig. 1, the multilayer circuit board is divided two-dimensionally into a plurality of areas using dividing lines including a plurality of straight lines parallel to each other.

For example, as shown in Fig. 3A, the multilayer circuit board 80 is divided by a dividing line L1 which extends straightly along y-direction, like in Fig. 2B, and then, as shown in Fig. 3B, the left divided area is further divided by a dividing line L2 which extends straightly along y-direction, and the right divided area is further divided by a dividing line L3 which extends straightly along y-direction, eventually, into four areas in total. This embodiment exemplifies that the multilayer circuit board is divided into four rectangular areas. But the multilayer circuit board may be divided into five or more areas.

As shown in Fig. 3C, a first divided area located in the most left side includes subsections 82c and 83c of the conductor patterns 82 and 83 in the first layer of the multilayer circuit board 80. A second divided area located in the second left side includes subsections 82d and 83d of the conductor patterns 82 and 83 in the first layer. A third divided area located in the third left side includes subsections 82e and 83e of the conductor patterns 82 and 83 in the first layer. A fourth divided area located in the fourth left side includes subsections 82f and 83f of the conductor patterns 82 and 83 in the first layer. Likewise with respect to a second layer and below, conductor patterns in each layer are also divided by the dividing lines L1 to L3 parallel to each other, into the first through fourth divided areas.

For each of the first through fourth divided areas, steps similar to the steps S4a to S7a of Fig. 1 are performed separately. For example, as shown in Fig. 3C, ports p11 and p13 are added on the right edge of the subsections 82c and 83c, and ports p12 and p14 are added on the left edge of the subsections 82d and 83d, and ports p5 and p7 are added on the right edge of the subsections 82d and 83d, and ports p6 and p8 are added on the left edge of the subsections 82e and 83e, and ports p17 and p19 are added on the right edge of the subsections 82e and 83e, and ports p18 and p19 are added on the left edge of the subsections 82f and 83f, respectively, in the first layer. Likewise with respect to a second layer and below, ports are added in each layer on edges of conductor pattern which has been created by area-division. Ports p9, p10, p15, p16, p21 and p22, as shown in Fig. 3C, are added on edges of conductor pattern residing in a layer other than the first layer. Each of the additive ports can be identified by parameters, such as layer number, conductor number, position coordinates (x, y), like as the initial ports.

Next, as in the step S5a of Fig. 1, individual signal analysis conditions for the initial ports and the additive ports are set up, respectively. For example, as shown in Fig. 3C, for each of the ports p1 to p22 residing in each layer, known parameters and unknown parameters of the signal analysis conditions are set up, respectively.

Next, as in the step S6a of Fig. 1, an EM analysis of the multilayer circuit board is performed by the divided area, based on the analysis conditions which are set up for each port. Next, as in the step S7a of Fig. 1, a result of the EM analysis over each of the divided areas is obtained. Consequently, unknown parameters of the ports p1 to p22 are calculated.

Next, as in the step S8 of Fig. 1, results of the EM analysis for each of the divided areas are integrated. Next, as in the step S9 of Fig. 1, results of the EM analysis for the whole board are obtained. In Fig. 3C, as in Fig. 2E, for the first and second divided areas the port p11 and the port p12 are coupled, and the port p13 and the port p14 are coupled, and the port p15 and the port p16 are coupled. For the second and third divided areas, the port p5 and the port p6 are coupled, and the port p7 and the port p8 are coupled, and the port p9 and the port p10 are coupled. For the third and fourth divided areas, the port p17 and the port p18 are coupled, and the port p19 and the port p20 are coupled, and the port p21 and the port p22 are coupled. Consequently, the original multilayer circuit board 80 as shown in Fig. 3A can be reconstructed. Results of the EM analysis over the whole multilayer circuit board 80 can be obtained by extracting unknown parameters calculated for the initial ports p1 to p4.

In this embodiment, the multilayer circuit board is divided two-dimensionally by dividing lines including a plurality of straight lines parallel to each other. In this manner, the dividing lines can be easily designated, and the number of the divided areas can be instantly increased, thereby quickly obtaining results of the simulation.

### (Embodiment 3)

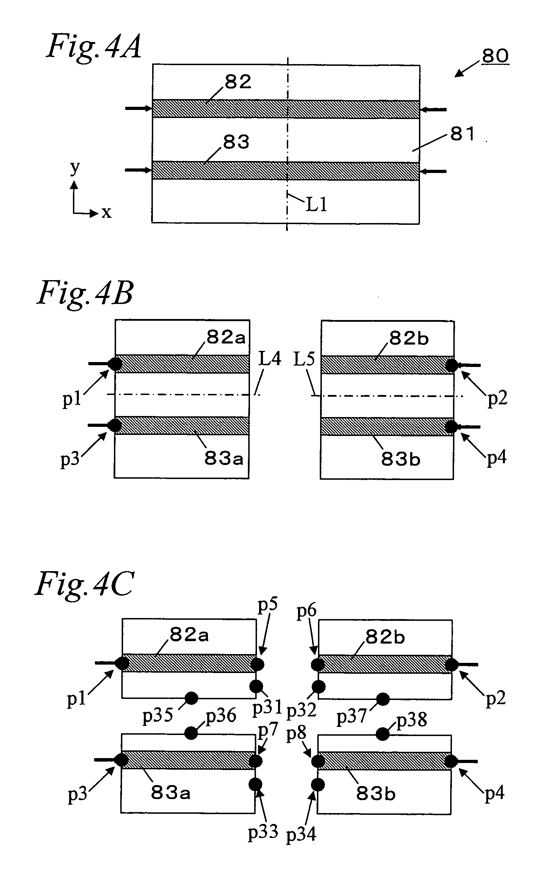

Figs. 4A to 4C are explanatory views illustrating yet another example of area division in the EM simulation according to the present invention. In this embodiment, operation of the EM simulation is similar to that as described above, but in the step S3 shown in Fig. 1, the multilayer circuit board is divided two-dimensionally into a plurality of areas using dividing lines including a plurality of straight lines perpendicular to each other.

For example, as shown in Fig. 4A, the multilayer circuit board 80 is divided by a dividing line L1 which extends straightly along y-direction, like in Fig. 2B, and then, as shown in Fig. 4B, the left divided area is further divided by a dividing line L4 which extends straightly along x-direction, and the right divided area is further divided by a dividing line L5 which extends straightly along x-direction, eventually, into four areas in total. This embodiment exemplifies that the multilayer circuit board is divided into four rectangular areas. But the multilayer circuit board may be divided into five or more areas.

As shown in Fig. 4C, a first divided area located in the upper left side includes the section 82a of the conductor pattern 82 in the first layer of the multilayer circuit board 80. A second divided area located in the lower left side includes the section 83a of the conductor pattern 83 in the first layer. A third divided area located in the upper right side includes the section 83b of the conductor pattern 83 in the first layer. A fourth divided area located in the lower right side includes the section 83b of the conductor pattern 83 in the first layer. Likewise with respect to a second layer and below, conductor patterns in each layer are also divided by the dividing lines L1 and L4, L5 perpendicular to each other, into the first through fourth divided areas.

For each of the first through fourth divided areas, steps similar to the steps S4a to S7a of Fig. 1 are performed separately. For example, as shown in Fig. 4C, a port p5 is added on the right edge of the section 82a, and a port p7 is added on the right edge of the section 83a, and a port p6 is added on the left edge of the section 82b, and a port p8 is added on the left edge of the section 83b, respectively, in the first layer. Likewise with respect to a second layer and below, ports are added in each layer on edges of conductor pattern which has been created by area-division. Ports p31 to p38 as shown in Fig. 4C are added on edges of conductor pattern residing in a layer other than the first layer. Each of the additive ports can be identified by parameters, such as layer number, conductor number, position coordinates (x, y), like as the initial ports.

In adding a port, when a position of one port located on the edge of a conductor pattern residing in one layer coincides with a position of another port located on the edge of another conductor pattern residing in another layer, one of the ports is preferably displaced to be represented on a display screen. For example, when the positions of the ports p31 to p34 coincide with the positions of the ports p5 to p8 residing in the first layer in a plan view of the board, the ports p31 to p34 are displaced to be represented on a display screen, as shown in Fig. 4C, thereby improving visibility and preventing a operator's mistake. Incidentally, even in case of displaying the displaced port, the actual position of the port is used for the EM analysis. In addition, there is a possibility that the actual position of the port is different from the position thereof on the display screen, and then it is also possible to perform the analysis in a states of intentionally displacing the position of the port.

Next, as in the step S5a of Fig. 1, individual signal analysis conditions for the initial ports and the additive ports are set up, respectively. For example, as shown in Fig. 4C, for each of the ports p1 to p8, p31 to p38 residing in each layer, known parameters and unknown parameters of the signal analysis conditions are set up, respectively.

Next, as in the step S6a of Fig. 1, an EM analysis of the multilayer circuit board is performed by the divided area, based on the analysis conditions which are set up for each port. Next, as in the step S7a of Fig. 1, a result of the EM analysis over each of the divided areas is obtained. Consequently, unknown parameters of the ports p1 to p8, p31 to p38 are calculated.

Next, as in the step S8 of Fig. 1, results of the EM analysis for each of the divided areas are integrated. Next, as in the step S9 of Fig. 1, results of the EM analysis for the whole board are obtained. In Fig. 4C, as in Fig. 2E, for the first and second divided areas the port p35 and the port p36 are coupled. For the first and third divided areas the port p5 and the port p6 are coupled, and the port p31 and the port p32 are coupled. For the second and fourth divided areas the port p7 and the port p8 are coupled, and the port p33 and the port p34 are coupled. For the third and fourth divided areas the port p37 and the port p38 are coupled. Consequently, the original multilayer circuit board 80 as shown in Fig. 4A can be reconstructed. Results of the EM analysis over the whole multilayer circuit board 80 can be obtained by extracting unknown parameters calculated for the initial ports p1 to p4.

In this embodiment, the multilayer circuit board is divided two-dimensionally by dividing lines including a plurality of straight lines perpendicular to each other. In this manner, the dividing lines can be easily designated, and the number of the divided areas can be instantly increased, thereby quickly obtaining results of the simulation.

Each of the above-described embodiments exemplifies that the multilayer circuit board is divided by a straight dividing line. But the board may be divided two-dimensionally by a dividing line including a polygonal line or a curved line, thereby enabling a board having more complex shapes of conductor patterns to be divided as few divided edges of the conductor patterns as possible. Consequently, running time of the simulation can be shortened.

Moreover, as method for designating a area dividing line, shapes of the dividing lines may be designated using a pointing device, such as mouse, while representing a plan view of the multilayer circuit board on a display screen. Thus, even though the multilayer circuit board has more complex shapes of conductor patterns, complex shapes of the dividing lines can be easily designated by visual operation.

### (Embodiment 4)

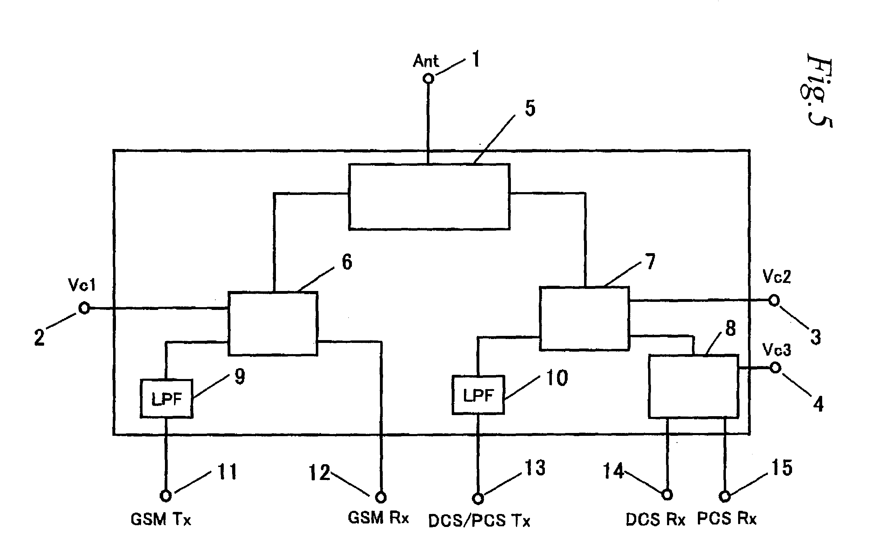

Fig. 5 is a block diagram showing an antenna switch circuit according to a fourth embodiment of the present invention. This antenna switch circuit board is configured of, as well known, an antenna terminal 1, power supply terminals 2, 3 and 4, a diplexer 5, switch circuits 6, 7 and 8, and filters 9 and 10. This example shows a antenna switch circuit board for GSM/DCS/PCS system, which is provided with a GSM transmitting terminal 11, a GSM receiving terminal 12, a DCS/PCS transmitting terminal 13, a DCS receiving terminal 14 and a PCS receiving terminal 15.

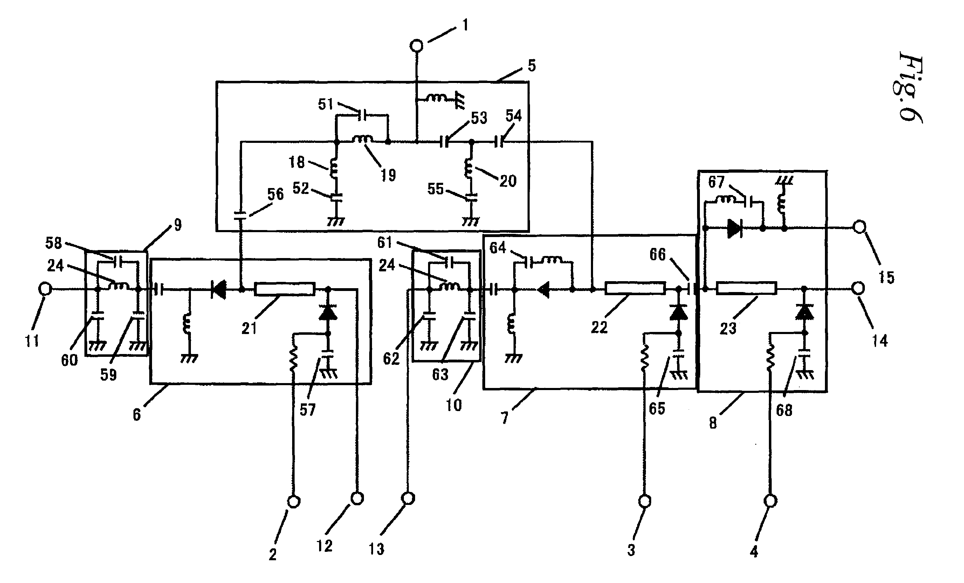

The block diagram of the antenna switch circuit shown in Fig. 5 is configured of such electric circuits as shown in Fig. 6.

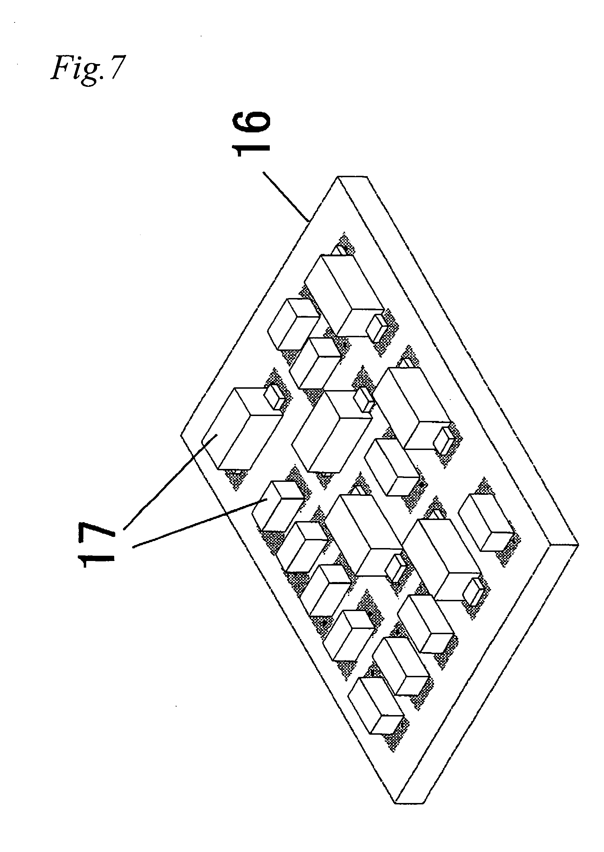

Fig. 7 shows the antenna switch circuit with various parts mounted on. A circuit board 16, on which various electronic parts 17 are mounted, is represented by the electric circuit shown in Fig. 6. Since the circuit in Fig. 6 is well known, only main parts will be described hereinafter.

In the diplexer 5 shown in Fig. 5, inductors 18, 19 and 20 are constituted of patterns which are incorporated into the circuit board 16 or depicted on the both sides of the circuit board 16. In the switch circuits 6, 7 and 8 shown in Fig. 5, inductors 21, 22 and 23 are incorporated into the circuit board 16 or depicted on the both sides of the circuit board 16. In the filters 9 and 10 shown in Fig. 5, inductors 24 and 25 are incorporated into the circuit board 16 or depicted on the both sides of the circuit board 16. Incidentally, combination of the inductor pattern, which is incorporated into the board 16 or depicted on the both sides of the board 16, and an inductor part mounted on the board 16 may constitute one inductor.

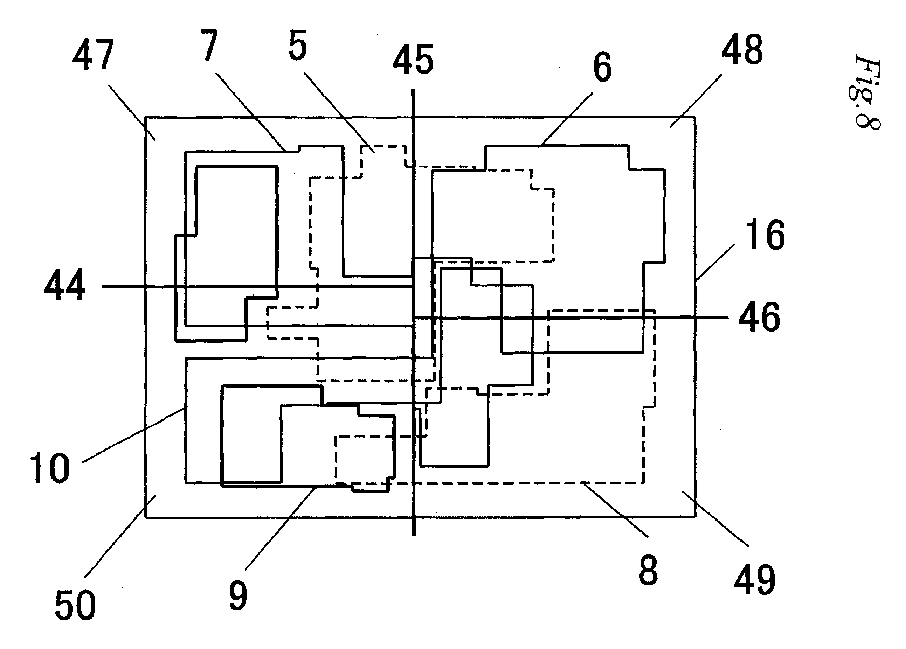

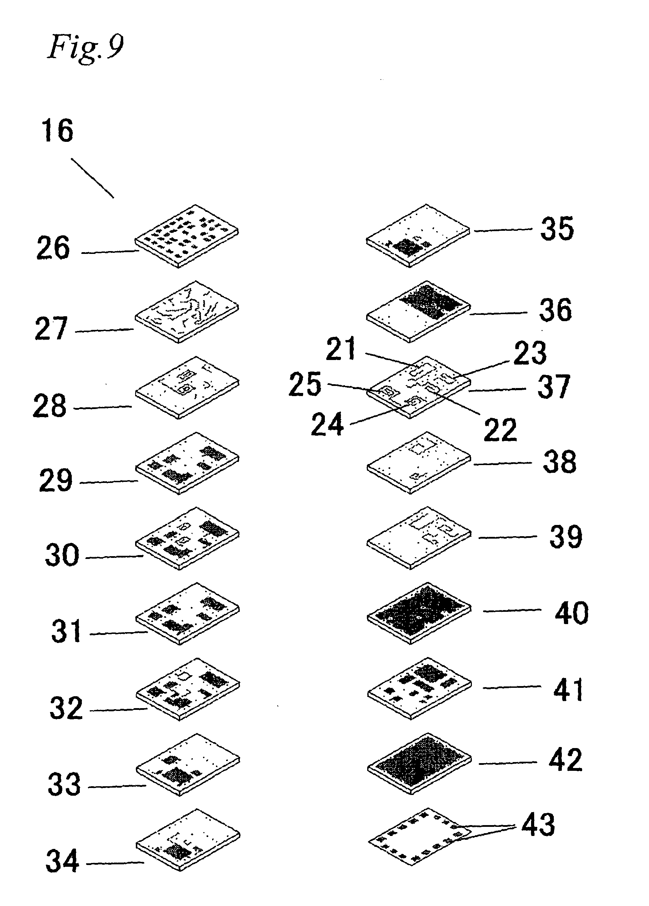

These incorporated inductance patterns 18 to 25 are specifically provided in the circuit board 16, as shown in Fig. 9. The circuit board 16 shown in Fig. 9 includes, for example, seventeen dielectric layers 26 to 42, which are laminated in this numerical sequence and integrated by sintering. The bottom of the dielectric layer 42 is provided with an electrode pattern 43. As shown in Fig. 9, the inductors 18 to 25 shown in Fig. 6 are distributed on each of the dielectric layers. The inductors 21, 23, 24 and 25 located on the dielectric layer 37 are distributed on four corner portions of this rectangular dielectric layer 37. This will be described specifically with reference to Fig. 8.

Fig. 8 shows a top view of the circuit board 16, which is provided with the diplexer 5, the switch circuits 6, 7 and 8, and the filters 9 and 10, shown in Fig. 5. Each of these circuits is specifically illustrated in Fig. 6. The inductors 18 to 25 are provided in the circuit board 16, as shown in Fig. 9.

Then, dividing lines 44, 45 and 46 shown in Fig. 8 are lines for dividing the circuit board 16 into four areas. In other words, the dividing line 45 is positioned at approximately half of the longer side of the rectangular circuit board 16. The dividing lines 44 and 46 are positioned across the shorter sides, but out of alignment with each other, in a slight shift. By this arrangement the circuit board 16 is divided into four areas in top view. In a state of four areas divided, for example, an area 47 includes the diplexer 5, the switch circuit 7 and the filter 10 as shown in Fig. 5, and an area 48 includes the diplexer 5, the switch circuits 6, 7 and 8. An area 49 similarly includes the diplexer 5, the switch circuits 6, 7 and 8, and an area 50 includes all the blocks of the diplexer 5, the switch circuits 6, 7 and 8, the filters 9 and 10. In this state, the patterns as shown in Fig. 9 will be designed using an EM simulation. The circuit board 16 shown in Fig. 8 includes the built-in inductors 18 to 25 and built-in capacitors 51 to 68 shown in Fig. 6. Fig. 9 does not illustrate the capacitors. These patterns with the built-in inductors 18 to 25 and the built-in capacitors 51 to 68 as noted above in Fig. 6 will be designed using the EM simulation. When designing such a plurality of circuit patterns which are laminated in a plurality of layers using the EM simulation, electromagnetic interference must be considered. Therefore, it will take a very long time to perform the whole simulation once.

In this embodiment, as shown in Fig. 8, the circuit board 16 is divided by the dividing lines 44, 45 and 46 into four areas 47 to 50, and design of patterns is optimized using the EM simulation over each of the areas.

In case of a large-scale circuit board, when dividing it into small size to perform the EM simulation, conductor patterns residing in such a divided area are decreased as compared with the whole, so that run time required for the EM simulation will be significantly shortened. But these multi-division of a circuit board and design of circuit patterns using the EM simulation over each of the divided areas may naturally cause an adverse effect due to such division, as compared with a result of the EM simulation over the whole board. The present inventors have studied a method for reducing such an adverse effect due to division of the circuit board, and have found out an optimal dividing method, in which as few spiral inductor patterns is cut off as possible. Among conductor patterns residing in a circuit board, the spiral inductor pattern is generally provided for increasing an inductance value. Therefore, in a case of simulation by dividing a pattern having such a large inductance, it will largely affect on characteristics, thereby causing a problem on practical commercialization of product. Accordingly, the present inventors propose that two or more spiral inductance patterns are not divided, that is, at most one spiral inductance pattern can be divided by a dividing line even when there are a plurality of spiral inductance patterns, so that the EM simulation of circuit patterns is performed over each of the areas divided by the dividing line.

More specifically, most important parts in designing of patterns are inductors, for example, the inductors 21, 23, 24 and 25 located on the dielectric layer 37 as shown in Fig. 9. Each of the inductors 21, 23, 24 and 25 is located in the vicinity of each of four corners. This location enables as few of these spiral inductance patterns as possible to be divided by the dividing lines 44 to 46 in Fig. 8. In other words, the dividing lines 44 to 46 is drawn so as not to divide two or more of the spiral inductance patterns, thereby performing the EM simulation over each of the areas 47 to 50.

Incidentally, the inductors 18 to 25 shown in Figs. 6 and 9 must be spiral inductance patterns when each attaining a desired value in a limited region. Therefore, the EM simulation with the large inductance pattern cut off may terribly affect on the result thereof. Accordingly, in this embodiment, as shown in Fig. 9, the inductance patterns 18 to 25 are required to be located as close to corners as possible, so as not to be cut off by the dividing lines 44 to 46.

In this embodiment, in order to make it easier to design a circuit using such a simulation, the circuit board is rectangular and spiral inductance patterns are located in advance close to at least three of corner portions of the circuit board. In other words, when dividing this rectangular circuit board, for example, into four areas, dividing lines are drawn in approximately centers of the one side and the other sides in contact with the one side of the circuit board, respectively. Then, each of spiral inductance patterns is located on each of the corner portions as described above, thereby enabling the dividing lines for performing the EM simulation over the divided area to be drawn so that most important spiral inductance patterns are not cut off.

In this case, the spiral inductance pattern is located on each of the three corner portions of the circuit board so that the shortest distance L1 from the apex of the corner portion to the spiral inductance pattern and a diameter L2 of a circumcircle of the spiral inductance pattern satisfy a relation: L1 ≤ L2, thereby making it easier to divide the circuit board without cutting off the spiral inductance pattern.

By employing such configuration of the circuit board, it takes only a few hours to design the circuit using the EM simulation in this embodiment, whereas the same EM simulation according to the conventional method requires several days for calculation. In addition, the former result obtained according to the present invention may be substantially similar to the latter result which consumes several days.

Further, by employing the design method using the EM simulation over each of small areas, various elements, such as inductor and capacitor, can be arranged in not only a lateral direction but also a lamination direction, thereby enabling the optimum design by briefly using the EM simulation. This can facilitate devices and circuit boards to be downsized, as compared with a case where elements are arranged in only a lateral direction.

Furthermore, by employing the design method using the EM simulation over each of small areas, in case of changing a particular shape of pattern residing in a particular area, the simulation over the particular area is performed once again, and the result of the simulation over the particular area is integrated with the result of the simulation over the other areas, so that the result of the simulation over the whole circuit board can be obtained. For example, when observing characteristics of changed shape of the inductor 21 located in the area 48 shown in Fig. 6, only the area 48 is newly analyzed and the original analysis results over the other areas are re-utilized to calculate the combination thereof. Consequently, characteristics of another pattern can be observed without analyzing the whole circuit board. This approach of such combination calculation can drastically shorten running time required for optimizing patterns in comparison to the conventional method.

### [INDUSTRIAL APPLICABILITY]

The present invention is useful because an EM analysis of a multilayer circuit board can run quickly to significantly reduce time and cost required for designing the circuit board.

## Claims

1. A method for analyzing an electromagnetic field of a circuit board based on shapes of conductor patterns and signal analysis conditions including steps of:
setting up initial shapes of conductor patterns in each layer of a multilayer circuit board;
setting up initial ports for input or output of an external signal in each conductor pattern;
dividing two-dimensionally the multilayer circuit board into a plurality of areas;
setting up additive ports on edges of the conductor pattern which has been created by area-division;
setting up individual analysis conditions for the initial ports and the additive ports, respectively;
performing an electromagnetic analysis of the multilayer circuit board by the divided area, based on the analysis conditions; and
integrating results of the electromagnetic analysis over each of the divided areas, thereby obtaining results of the electromagnetic analysis over the whole circuit board.

2. The method for analyzing an electromagnetic field of a circuit board according to Claim 1, wherein in the step of dividing the multilayer circuit board into a plurality of areas, the multilayer circuit board is divided two-dimensionally into a plurality of areas using dividing lines including a plurality of straight lines parallel to each other.

3. The method for analyzing an electromagnetic field of a circuit board according to Claim 1, wherein in the step of dividing the multilayer circuit board into a plurality of areas, the multilayer circuit board is divided two-dimensionally into a plurality of areas using dividing lines including a plurality of straight lines perpendicular to each other.

4. The method for analyzing an electromagnetic field of a circuit board according to Claim 1, wherein in the step of dividing the multilayer circuit board into a plurality of areas, the multilayer circuit board is divided two-dimensionally into a plurality of areas using dividing lines including a polygonal line or a curved line.

5. The method for analyzing an electromagnetic field of a circuit board according to Claim 1, wherein in the step of dividing the multilayer circuit board into a plurality of areas, shapes of the dividing lines are designated using a pointing device while representing a plan view of the multilayer circuit board on a display screen.

6. The method for analyzing an electromagnetic field of a circuit board according to Claim 1, including a step of calculating the number of the edges of the conductor pattern created by area-division.

7. The method for analyzing an electromagnetic field of a circuit board according to Claim 6, wherein in the step of setting up additive ports, the ports are added, the number of which corresponds to the calculated number of the edges.

8. The method for analyzing an electromagnetic field of a circuit board according to Claim 1, wherein in the step of setting up additive ports, the ports are added in the center of the edge.

9. The method for analyzing an electromagnetic field of a circuit board according to Claim 1, wherein, when a position of one port located on the edge of a conductor pattern residing in one layer coincides with a position of another port located on the edge of another conductor pattern residing in another layer, one of the ports is displaced to be represented on a display screen.

10. The method for analyzing an electromagnetic field of a circuit board according to Claim 1, including steps of:
changing the shape of the conductor pattern residing in a particular divided area, to perform again the electromagnetic analysis over the particular divided area; and
integrating a result of the electromagnetic analysis over the divided area with the result of the electromagnetic analysis over the another divided area, thereby obtaining results of the electromagnetic analysis over the whole circuit board.

11. An apparatus for analyzing an electromagnetic field of a circuit board based on shapes of conductor patterns and signal analysis conditions comprising:
means for setting up initial shapes of conductor patterns in each layer of a multilayer circuit board;
means for setting up initial ports for input or output of an external signal in each conductor pattern;
means for dividing two-dimensionally the multilayer circuit board into a plurality of areas;
means for setting up additive ports on edges of the conductor pattern which is created by area-division;
means for setting up individual analysis conditions for the initial ports and the additive ports, respectively;
means for performing an electromagnetic analysis of the multilayer circuit board by the divided area, based on the analysis conditions; and
means for integrating results of the electromagnetic analysis over each of the divided areas, thereby obtaining results of the electromagnetic analysis over the whole circuit board.

12. A circuit board with a rectangular shape comprising:
a plurality of layers having conductor patterns; and
a plurality of spiral inductance patterns provided in the conductor patterns;
wherein three out of the plurality of spiral inductance patterns are located on at least three of corner portions of the circuit board.

13. The circuit board according to Claim 12, wherein the spiral inductance pattern is located on each of the three corner portions of the circuit board so that the shortest distance L1 from the apex of the corner portion to the spiral inductance pattern and a diameter L2 of a circumcircle of the spiral inductance pattern satisfy a relation: L1 ≤ L2.

14. A lamination device comprising:
the circuit board according to Claim 12 or 13; and
a semiconductor integrated circuit mounted on the circuit board.

15. A method for designing a circuit board including a plurality of layers having conductor patterns in which a plurality of spiral inductance patterns are provided, including steps of:
dividing the circuit board into a plurality of divided areas using a dividing line; and
designing a circuit pattern over each of the divided areas using simulation,
wherein the dividing line is set up so as not to cut off two or more out of the plurality of spiral inductance patterns provided in the circuit board.

16. The method for designing a circuit board including a plurality of layers having conductor patterns in which a plurality of spiral inductance patterns are provided, according to Claim 15, wherein three out of the plurality of spiral inductance patterns are located on at least three of corner portions of the circuit board.
